# EUROPEAN PATENT APPLICATION

(11) **EP 4 841 345 A1**
(43) Date of publication of application: **18.11.2026**
(21) Application number: 26176899.8
(22) Date of filing: 06.05.2026
(51) Int. Cl.: G03F 1/24, G03F 1/32, G03F 1/54

(54) **REFLECTIVE PHOTOMASK BLANK, REFLECTIVE PHOTOMASK, AND METHOD FOR PRODUCING SAME**

(30) Priority: 15.05.2025 JP 2025082020
(71) Applicant: SHIN-ETSU CHEMICAL CO., LTD., Chiyoda-ku, Tokyo 1000005 (JP)
(72) Inventor: KAWAMURA, Ryoto, Joetsu-shi, 9428601 (JP); ARATA, Yuta, Joetsu-shi, 9428601 (JP); OGOSE, Taiga, Joetsu-shi, 9428601 (JP)
(74) Representative: Mewburn Ellis LLP

(57) **Abstract**

A reflective photomask blank having a light-absorbing film formed on a substrate, wherein the light-absorbing film has a thickness of 35-40 nm, is formed of a material containing platinum and ruthenium, and has a platinum content of 40 at% or more and less than 60 at%, a ruthenium content of more than 40 at% and 60 at% or less, a total content of platinum and ruthenium of 96 at% or more as an overall average, the platinum content on the side farthest from the substrate is more than 50 at% and 90 at% or less, and the platinum content intermittently or continuously decreasing in part or whole of the light-absorbing film along the thickness direction thereof from the side farthest from the substrate toward the substrate side, and the light-absorbing film has a reflectance of 3-10% and a phase difference of 200-230 degrees with respect to exposure light.

## Description

### TECHNICAL FIELD

The present invention relates to a reflective photomask for use in production of semiconductor devices, a method for producing the reflective photomask, and a reflective photomask blank for use in producing the reflective photomask as a material for the reflective photomask.

### BACKGROUND

With miniaturization of semiconductor devices, particularly, high integration of large-scale integrated circuits, high pattern resolution has been required for projection exposure. In the circumstances, in the field of photomasks, a phase-shift photomask has been developed as a means for improving the resolution of transferred pattern. The principle of the phase shift method is as follows. The phase of the transmitted light beam passed through the opening of the phase-shift film of a phase-shift photomask is controlled so as to be inverted by about 180 degrees to the phase of the transmitted light beam passed through the portion of the phase-shift film adjacent to the opening, so that the transmitted light beams interfere at the boundary between the opening and the portion adjacent to the opening, thereby reducing in light intensity, with the result that the resolution and focal depth of the transferred pattern are improved. A photomask based on this principle is generally referred to as a phase-shift photomask. The phase-shift photomask of this case is a type of transmissive photomask transmitting exposure light.

The phase-shift photomask blank, which is used as a material for a phase-shift photomask in producing a phase-shift photomask, most commonly has a structure where a phase-shift film is stacked on a transparent substrate such as a glass substrate, and a film formed of a material containing chromium (Cr) is stacked on the phase-shift film. The phase-shift film usually has a phase difference of 175 to 185 degrees and a transmittance of about 6 to 30% to exposure light. Most of the phase-shift films are films containing silicon (Si), in particular, films formed of a material containing molybdenum (Mo) and silicon (Si). Also, the film formed of the material containing chromium (Cr) is used in combination with the phase-shift film and controlled to have a thickness providing a desired optical density. It is common to use the film formed of the material containing chromium (Cr) as a light shielding film and at the same time as an etching mask for etching the phase-shift film.

As a method for producing a phase-shift photomask from a phase-shift photomask blank, which is obtained by forming a phase-shift film formed of a material containing silicon (Si) and a light shielding film formed of a material containing chromium (Cr) in this order on a transparent substrate, by patterning the phase-shift film, specifically, the following method is commonly known. First, a resist film is formed on the light shielding film formed of a material containing chromium (Cr) of a phase-shift photomask blank, and a pattern is drawn on the resist film with light or an electron beam and developed to form a resist pattern. Then, the light shielding film formed of a material containing chromium (Cr) is dry-etched using a chlorine-based gas with the resist pattern used as an etching mask to form a pattern of the light shielding film. Furthermore, the phase-shift film formed of a material containing silicon (Si) is dry-etched using a fluorine-based gas with the pattern of the light shielding film used as an etching mask to form a pattern of the phase-shift film, and thereafter, the resist pattern is removed, and the pattern of the light shielding film is removed by dry-etching using a chlorine-based gas.

In this case, the light shielding film is allowed to remain outside the portion where the pattern (circuit pattern) of the phase-shift film is formed, and the outer peripheral edge portion of the phase-shift photomask is used as a light shielding portion (light shielding pattern) having an optical density 3 or more as the total optical density of the phase-shift film and the light shielding film. This is performed for preventing leakage of the exposure light from the outer peripheral edge portion of the phase-shift photomask to irradiate the resist film on an adjacent chip of a wafer from the portion located outside the circuit pattern when the circuit pattern is transferred to the wafer by a wafer exposure apparatus. As a method for forming such a light shielding pattern, the method commonly used includes forming a new resist film after the formation of the pattern of the phase-shift film and the removal the resist pattern, forming a resist pattern, in which the resist film remains on the outer peripheral edge portion of the light shielding film by pattern drawing and development, and etching a film formed of a material containing chromium (Cr) with the resist pattern used as an etching mask to leave the light shielding film on the outer peripheral edge portion of the phase-shift photomask.

In a phase-shift photomask blank requiring highly accurate pattern formation, dry etching using gas plasma is mainly used as the etching. For dry etching of a film formed of a material containing chromium (Cr), dry etching using a chlorine-based gas (chlorine-based dry etching) is used, whereas for dry etching of a film formed of a material containing silicon (Si) or a film formed of a material containing molybdenum (Mo) and silicon (Si), dry etching using a fluorine-based gas (fluorine-based dry etching) is used. In particular, it is known that, in dry etching of a film formed of a material containing chromium (Cr), if an etching gas containing 10 to 25 vol% of oxygen gas (O₂ gas) relative to chlorine gas (Cl₂ gas) is used, chemical reactivity is increased and an etching rate is improved.

With the miniaturization of circuit patterns, a technique for finely forming a circuit pattern of a phase-shift photomask is also required. In particular, an assist pattern of the line pattern, which assists the resolution of the main pattern of the phase-shift photomask, is required to be formed smaller than the main pattern so as not to be transferred to a wafer when the circuit pattern is transferred to the wafer by a wafer exposure apparatus. In a phase-shift photomask for the 10-nm half pitch generation of a line and space pattern on a wafer, the line width of the assist pattern of the line pattern in the circuit of the phase-shift photomask is required to be about 40 nm.

A chemically amplified resist that can form a fine pattern is composed of, e.g., a base resin, an acid generator, and a surfactant. Since many reactions in which an acid generated by light exposure acts as a catalyst can be applied, the sensitivity can be increased. If the chemically amplified resist is used, it is possible to form a mask pattern such as a fine phase-shift film pattern of 0.1 µm or less in line width. A resist is applied onto the photomask blank by spin coating using a resist coater.

Furthermore, recently a higher pattern resolution has been required for projection exposure. However, even if a transmissive phase-shift photomask is used, it comes to be difficult to obtain a desired pattern resolution. Because of this, in the logic 7 nm-generation and later, EUV lithography (EUVL) using extreme ultraviolet region light (EUV light) for exposure light has come to be used.

Since EUV light is easily absorbed by any substance, transmission lithography such as photolithography using conventional ArF excimer laser light cannot be used. Because of this, a reflecting optical system is used in the EUVL. The wavelength of EUV light used in the EUVL is 13 to 14 nm and the wavelength of conventional ArF excimer laser light is 193 nm. Thus, the exposure wavelength is shorter than that of conventional photolithography using ArF excimer laser light and enables transfer of a finer pattern in a photomask.

The photomask used in the EUVL, which is a reflective photomask reflecting exposure light by the photomask, commonly has a structure where a reflective film reflecting EUV light, a protective film for protecting the reflective film, and a pattern of a light-absorbing film absorbing EUV light are formed in this order on a substrate such as a glass substrate. As the reflective film, a multilayer reflective film is used, which is obtained by alternately stacking low refractive index layers and high refractive index layers to enhance the reflectance with respect to EUV light applied to the surface of the reflective film. Usually, as the low refractive index layer of the multilayer reflective film, a molybdenum (Mo) layer is used, whereas, as the high refractive index layer, a silicon (Si) layer is used. As the protective film, a ruthenium (Ru) film is usually used. In contrast, for the light-absorbing film, a material having a high absorption coefficient for EUV light, specifically, for example, a material containing chromium (Cr) or tantalum (Ta) as a principal component is used. In the early generation EUVL, a binary reflective photomask having no light reflection by the light-absorbing film was used.

As a method for producing a reflective photomask from a reflective photomask blank, which is formed by forming a reflective film reflecting EUV light, a protective film protecting the reflective film, and a light-absorbing film absorbing EUV light in this order on a substrate, by patterning the light-absorbing film, specifically, the following method is commonly known. First, a resist film is formed on the light-absorbing film, a pattern is drawn on the resist film with light or an electron beam, and developed to form a resist pattern. Then, the light-absorbing film is patterned with the resist pattern used as an etching mask to form a pattern of the light-absorbing film, and thereafter the resist pattern is removed.

In the EUVL of the logic 3 nm-generation or later, in order to form a finer pattern on a wafer, a reflective photomask (reflective phase-shift photomask) having a pattern of a light-absorbing film having a phase shift function is used. If the reflective phase-shift photomask is used, it is possible to obtain a higher wafer transfer characteristic than that of the binary reflective photomask. The wafer transfer characteristic can be expressed by normalized image log slope (NILS) corresponding to the contrast of the light intensity transferred to a wafer. NILS can be obtained according to the following formula: $NILS = \left(dI/dx\right) / \left(W\times Ith\right)$ wherein W is a desired pattern dimension, Ith is a threshold of the light intensity providing W, and dI/dx is a gradient of the aerial image. When the value of NILS is large, the optical image becomes sharp, and the dimensional controllability of the resist pattern on the wafer is improved. Because of this, in order to form a finer pattern on a wafer, it is effective that the NILS value is large. A reflective phase-shift photomask, which can provide a larger NILS value than a binary reflective photomask, is used.

NILS is affected by the size of the pattern on a wafer, the pitch of the pattern, the reflectance of the reflective phase-shift photomask with respect to exposure light, and the phase difference with respect to the exposure light. For example, in the line and space pattern on a wafer where the size of the line and space are each 18 nm, NILS takes a favorable value when the reflectance with respect to the exposure light is about 4% and the phase difference with respect to the exposure light is about 215 degrees.

Further, in the reflective phase-shift photomask, exposure light is obliquely incident and obliquely reflected on the reflective photomask. The phase-shift film needs to have a predetermined thickness or more to absorb part of the exposure light and provide a predetermined reflectance. If the phase-shift film is thick, the shadowing effect where the exposure light is blocked by the phase-shift film when the exposure light is incident and reflected becomes more influential. In order to reduce the influence of the shadowing effect, a thinner phase-shift film providing a predetermined reflectance is advantageous.

Furthermore, in the production process for the reflective phase-shift photomask and also during use of the reflective phase-shift photomask and in pattern correction, the light-absorbing film is exposed to cleaning with sulfuric acid and cleaning with an alkali. If the cleaning with sulfuric acid or cleaning with an alkali is repeated, the thickness of the light-absorbing film decreases. In the light-absorbing film having a phase shift function, if the thickness thereof changes even slightly, the phase difference and reflectance with respect to the EUV light greatly change. Because of this, in order to stably form a pattern having a desired size on a wafer, a light-absorbing film having a phase shift function is required to have higher cleaning resistance.

JP-A 2024-142177 (Patent Document 1) discloses a reflective mask blank having a substrate, a multilayer reflective film provided on the substrate, and a thin film provided on the multilayer reflective film, wherein the thin film has a lower layer and an upper layer provided on the lower layer, the lower layer is composed of a material containing an amorphous structure or a microcrystalline structure, and the crystallinity of the upper layer is higher than that of the lower layer. Also, JP-A 2024-142177 (Patent Document 1) discloses, as a thin film provided on the multilayer reflective film, specifically, an absorber film composed of a lower layer of a CrN film (a layer in contact with a protective film, or a buffer layer) and an upper layer such as a PtRu film, and discloses that the absorber film has a phase shift function.

### Citation List

Patent Document 1: JP-A 2024-142177

### SUMMARY OF THE INVENTION

JP-A 2024-142177 (Patent Document 1) discloses a film having a chromium (Cr) content of 90 at% and a nitrogen (N) content of 10 at% as the CrN film for the lower layer, and a film having a platinum (Pt) content of 22 at% at minimum and 53 at% at maximum as a film containing platinum (Pt) and ruthenium (Ru) such as the PtRu film for the upper layer. The total thickness of these layers, that is, the thickness of the absorber film, is 30 nm.

However, in a case where the content of platinum (Pt) is 50 atomic % or less, if cleaning with sulfuric acid or cleaning with alkali is repeated, the thickness of the light-absorbing film greatly decreases. In contrast, when the content of platinum (Pt) is high, since platinum (Pt) has a large extinction coefficient k to ruthenium (Ru), the reflectance as a phase-shift film is lower than a preferable reflectance of 3 to 10%, and the phase difference as a phase-shift film greatly deviates from a preferable phase difference of about 215 degrees, with the result that the wafer transfer characteristic (NILS) deteriorates.

Furthermore, in the case of the film containing platinum (Pt) and ruthenium (Ru), a pattern can be corrected by processing with dry etching performed with activating a fluorine-based gas by an electron beam. However, in an absorber film composed of a lower layer of a CrN film and an upper layer of, e.g., the PtRu film, the CrN film cannot be processed by dry etching performed with activating a fluorine-based gas by an electron beam, and correction must be made by dry etching performed with activating a chlorine-based gas by an electron beam. Because of this, in the absorber film composed of the CrN film as the lower layer and, e.g., the PtRu film as the upper layer, correction is performed by two types of etching using different etching gases. As a result, the success rate of correction to the pattern of the light-absorbing film is significantly reduced, compared to the case where correction is made by a single type of etching.

The present invention has been made to solve the above problems. An object of the present invention is to provide a reflective photomask blank having, as a light-absorbing film having a phase shift function, a light-absorbing film which has high resistance to cleaning with sulfuric acid and cleaning with an alkali, has high wafer transfer characteristic (NILS is large), and can be easily processed by dry etching performed with activating a fluorine-based gas by an electron beam; a reflective photomask having such a pattern of the light-absorbing film, and a method for producing a reflective photomask from the reflective photomask blank.

As a result of intensive studies conducted with a view to solving the above problems, the present inventors made the following finding: in a reflective photomask blank and a reflective photomask, a light-absorbing film was formed of a material containing platinum (Pt) and ruthenium (Ru) as principal components in predetermined contents and constituted such that the content of platinum (Pt) on the side of the light-absorbing film farthest from a substrate is set to be high, whereas the content of platinum (Pt) decreases along the thickness direction of the light-absorbing film from the side of the light-absorbing film farthest from the substrate toward the substrate side. Owing to the constitution, it was found that a relatively thin light-absorbing film having high wafer transfer characteristic (NILS) and a phase shift function has high resistance to cleaning with sulfuric acid and cleaning with an alkali, and can be easily processed with dry etching performed with activating a fluorine-based gas by an electron beam at the time of correction of a pattern of the light-absorbing film. Based on the finding, the present invention was achieved.

Accordingly, the present invention provides the following reflective photomask blank, reflective photomask, and method for producing the reflective photomask.
1. A reflective photomask blank including a substrate, a multilayer reflective film formed on the substrate and reflecting exposure light which is extreme ultraviolet region light, a protective film formed on the multilayer reflective film for protecting the multilayer reflective film, and a light-absorbing film formed on the protective film in contact with the protective film, absorbing the exposure light, and having a phase shift function, wherein
   the light-absorbing film has a thickness of 35 nm or more and 40 nm or less,
   the light-absorbing film is formed of a material containing platinum (Pt) and ruthenium (Ru),
   as an overall average in the light-absorbing film, a content of platinum (Pt) is 40 atomic % or more and less than 60%, a content of ruthenium (Ru) is more than 40 atomic % and 60 atomic % or less, and a total content of platinum (Pt) and ruthenium (Ru) is 96 atomic % or more,
   a content of platinum (Pt) on the side of the light-absorbing film farthest from the substrate is more than 50 atomic % and 90 atomic % or less,
   a content of platinum (Pt) intermittently or continuously decreases in part or whole of the light-absorbing film along the thickness direction thereof from the side of the light-absorbing film farthest from the substrate toward the substrate side, and
   the light-absorbing film has a reflectance of 3% or more and 10% or less with respect to the exposure light and a phase difference of 200 degrees or more and 230 degrees or less with respect to the exposure light.
2. The reflective photomask blank according to 1, wherein a content of platinum (Pt) on the side of the light-absorbing film closest to the substrate is 40 atomic % or more and 50 atomic % or less.
3. The reflective photomask blank according to 1, wherein the content of platinum (Pt) on the side of the light-absorbing film farthest from the substrate is 52 atomic % or more.
4. The reflective photomask blank according to 1, wherein, when the protective film and the light-absorbing film are etched under the same conditions by dry etching performed with activating a fluorine-based gas by an electron beam, a ratio of an etching rate of the light-absorbing film to an etching rate of the protective film is 50 or more.
5. The reflective photomask blank according to 1, wherein the protective film is formed of a material containing rhodium (Rh).
6. The reflective photomask blank according to 1, further including a hard mask film formed on the light-absorbing film in contact with the light-absorbing film.
7. The reflective photomask blank according to 6, wherein the hard mask film is formed of a material that has resistance to fluorine-based dry etching and can be etched by chlorine-based dry etching.
8. The reflective photomask blank according to 7, wherein the hard mask film is formed of a material containing chromium (Cr), and has a thickness of 2 nm or more and 14 nm or less.
9. A reflective photomask including a substrate, a multilayer reflective film formed on the substrate and reflecting exposure light which is extreme ultraviolet region light, a protective film formed on the multilayer reflective film for protecting the multilayer reflective film, and a pattern of a light-absorbing film formed on the protective film in contact with the protective film, absorbing the exposure light, and having a phase shift function, wherein
   the light-absorbing film has a thickness of 35 nm or more and 40 nm or less,
   the light-absorbing film is formed of a material containing platinum (Pt) and ruthenium (Ru),
   as an overall average in the light-absorbing film, a content of platinum (Pt) is 40 atomic % or more and less than 60%, a content of ruthenium (Ru) is more than 40 atomic % and 60 atomic % or less, and a total content of platinum (Pt) and ruthenium (Ru) is 96 atomic % or more,
   a content of platinum (Pt) on the side of the light-absorbing film farthest from the substrate is more than 50 atomic % and 90 atomic % or less,
   a content of platinum (Pt) intermittently or continuously decreases in part or whole of the light-absorbing film along the thickness direction thereof from the side of the light-absorbing film farthest from the substrate toward the substrate side, and
   the light-absorbing film has a reflectance of 3% or more and 10% or less with respect to the exposure light and a phase difference of 200 degrees or more and 230 degrees or less with respect to the exposure light.
10. The reflective photomask according to 9, wherein a content of platinum (Pt) on the side of the light-absorbing film closest to the substrate is 40 atomic % or more and 50 atomic % or less.
11. The reflective photomask according to 9, wherein the content of platinum (Pt) on the side of the light-absorbing film farthest from the substrate is 52 atomic % or more.
12. The reflective photomask according to 9, wherein, when the protective film and the light-absorbing film are etched under the same conditions by dry etching performed with activating a fluorine-based gas by an electron beam, a ratio of an etching rate of the light-absorbing film to an etching rate of the protective film is 50 or more.
13. The reflective photomask according to 9, wherein the protective film is formed of a material containing rhodium (Rh).
14. A method for producing a reflective photomask including a pattern of the light-absorbing film from the reflective photomask blank according to any one of 6 to 8, including the steps of:
   (A) forming a resist film in contact with the side of the hard mask film farthest from the substrate,
   (B) patterning the resist film to form a resist pattern,
   (C) patterning the hard mask film by dry etching using a chlorine-based gas with the resist pattern used as an etching mask to form a pattern of the hard mask film,
   (D) removing the resist pattern,
   (E) patterning the light-absorbing film by dry etching using a fluorine-based gas with the pattern of the hard mask film used as an etching mask to form a pattern of the light-absorbing film, and
   (F) removing the pattern of the hard mask film by dry etching using a chlorine-based gas.

### ADVANTAGEOUS EFFECTS

The light-absorbing film of the reflective photomask blank and the pattern of the light-absorbing film of the reflective photomask of the present invention, as a light-absorbing film having a phase shift function, have high resistance to cleaning with sulfuric acid and cleaning with an alkali, are low in thickness reduction by cleaning with sulfuric acid and cleaning with an alkali, and can be easily processed by dry etching performed with activating a fluorine-based gas by an electron beam at the time of correction of the pattern of the light-absorbing film. The reflective photomask having the pattern of the light-absorbing film has a high wafer transfer characteristic (NILS is large). Because of this, the reflective photomask of the present invention provides transfer of a miniaturized line-and-space pattern on a wafer, and a good transfer pattern.

### BRIEF DESCRIPTION OF DRAWINGS

FIG. 1 is a cross-sectional view illustrating an example of a first aspect of a reflective photomask blank according to the present invention.
FIG. 2 is a cross-sectional view illustrating an example of a second aspect of the reflective photomask blank according to the present invention.
FIG. 3 is a cross-sectional view illustrating an example of a third aspect of the reflective photomask blank according to the present invention.
FIG. 4 is a cross-sectional view illustrating an example of a first aspect of the reflective photomask of the present invention.
FIG. 5 is a cross-sectional view illustrating an example of a second aspect of the reflective photomask of the present invention.
FIGS. 6A to 6F are cross-sectional views for explaining steps of producing the reflective photomask of the second aspect according to the present invention from the reflective photomask blank of the second aspect according to the present invention.

### FURTHER EXPLANATIONS; OPTIONS AND PREFERENCES

Hereinafter, the present invention is described in more detail.

The reflective photomask blank according to the present invention has a substrate, a multilayer reflective film formed on the substrate (on a surface of the substrate (one of the main surfaces)), a protective film formed on the multilayer reflective film, and a light-absorbing film formed on the protective film. The reflective photomask blank of the present invention may further have a hard mask film formed on the light-absorbing film. Furthermore, the reflective photomask blank of the present invention may further have a resist film formed directly or via another film on the light-absorbing film or the hard mask film.

From the reflective photomask blank of the present invention, a reflective photomask, which has, for example, a substrate, a multilayer reflective film formed on the substrate, a protective film formed on the multilayer reflective film, and a pattern (circuit pattern or photomask pattern) of a light-absorbing film formed on the protective film, can be obtained.

The reflective photomask, when it is held on a mask stage of an exposure apparatus, is usually immobilized by an electrostatic chuck. Because of this, the reflective photomask blank and reflective photomask of the present invention may further have a conductive film (back surface film) for immobilizing the reflective photomask by an electrostatic chuck on the substrate (on the back surface of a substrate (surface opposite to the surface on which, e.g., the multilayer reflective film, is formed, that is, the other main surface)).

Hereinafter, structures of the reflective photomask blank and reflective photomask of the present invention are described with reference to the drawings. In the description of the drawings, the same components are designated by the same reference numerals, and the description thereof may be omitted. Furthermore, the drawings may be shown in an expanded form for convenience, and the dimensional ratios of the individual components are not necessarily the same as actual ones.

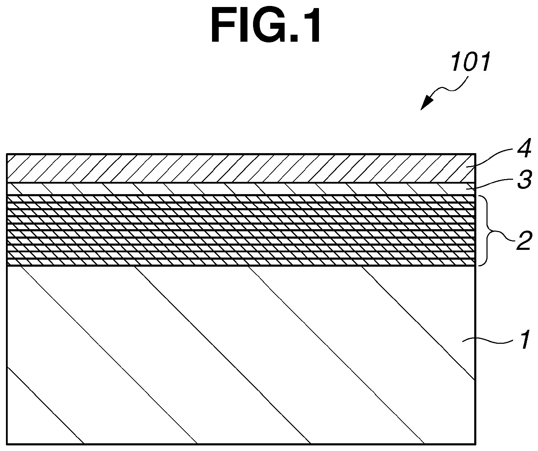

FIG. 1 is a cross-sectional view illustrating an example of a first aspect of a reflective photomask blank according to the present invention. The reflective photomask blank 101 has a substrate 1, a multilayer reflective film 2 formed on one of the main surfaces of the substrate 1 in contact with the substrate 1, a protective film 3 formed on the multilayer reflective film 2 in contact with the multilayer reflective film 2, and a light-absorbing film 4 formed on the protective film 3 in contact with the protective film 3.

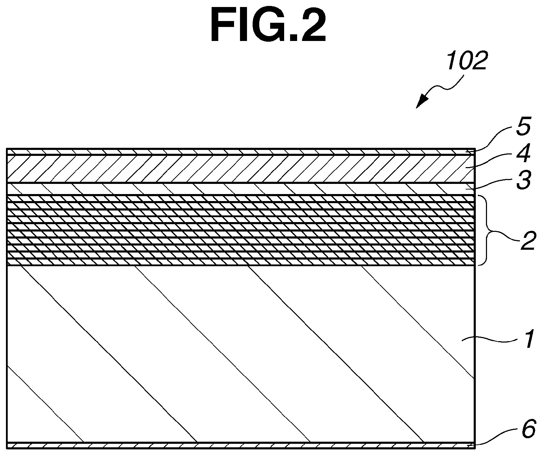

FIG. 2 is a cross-sectional view illustrating an example of a second aspect of the reflective photomask blank according to the present invention. The reflective photomask blank 102 has a substrate 1, a multilayer reflective film 2 formed on one of the main surfaces of the substrate 1 in contact with the substrate 1, a protective film 3 formed on the multilayer reflective film 2 in contact with the multilayer reflective film 2, a light-absorbing film 4 formed on the protective film 3 in contact with the protective film 3, and a hard mask film 5 formed on the light-absorbing film 4 in contact with the light-absorbing film 4. Furthermore, a conductive film 6 is provided, which is formed on and in contact with the other main surface of the substrate 1.

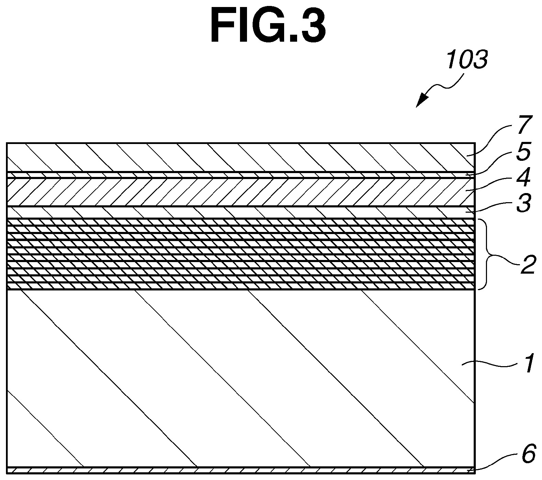

FIG. 3 is a cross-sectional view illustrating an example of a third aspect of the reflective photomask blank according to the present invention. The reflective photomask blank 103 has a substrate 1, a multilayer reflective film 2 formed on one of the main surfaces of the substrate 1 in contact with the substrate 1, a protective film 3 formed on the multilayer reflective film 2 in contact with the multilayer reflective film 2, a light-absorbing film 4 formed on the protective film 3 in contact with the protective film 3, a hard mask film 5 formed on the light-absorbing film 4 in contact with the light-absorbing film 4, and a resist film 7 formed on the hard mask film 5 in contact with the hard mask film 5. Furthermore, a conductive film 6 is provided, which is formed on and in contact with the other main surface of the substrate 1.

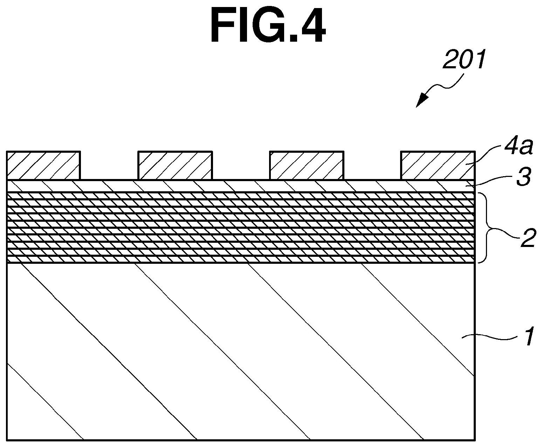

FIG. 4 is a cross-sectional view illustrating an example of a first aspect of the reflective photomask according to the present invention. The reflective photomask 201 has a substrate 1, a multilayer reflective film 2 formed on the substrate 1 in contact with the substrate 1, a protective film 3 formed on the multilayer reflective film 2 in contact with the multilayer reflective film 2, and a pattern 4a of a light-absorbing film formed on the protective film 3 in contact with the protective film 3.

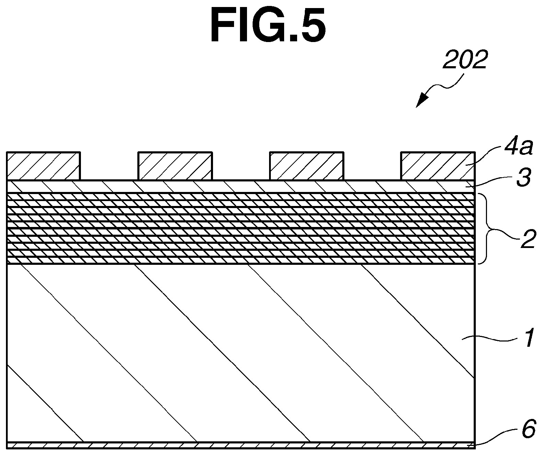

FIG. 5 is a cross-sectional view illustrating an example of a second aspect of the reflective photomask of the present invention. The reflective photomask 202 has a substrate 1, a multilayer reflective film 2 formed on the substrate 1 in contact with the substrate 1, a protective film 3 formed on the multilayer reflective film 2 in contact with the multilayer reflective film 2, and a pattern 4a of a light-absorbing film formed on the protective film 3 in contact with the protective film 3. Furthermore, a conductive film 6 is provided, which is formed on and in contact with the other main surface of the substrate 1.

The type and sizes of substrate are not particularly limited. The substrate of the reflective photomask blank and the reflective photomask may or may not be transparent at the exposure wavelength. As the substrate, for example, a glass substrate such as a quartz substrate can be used. Furthermore, the substrate is preferably a substrate called, for example, 6025 substrate, which has a size of 6 inches square and a thickness of 0.25 inches, and is defined in the SEMI standard. The 6025 substrate is usually expressed, if the SI unit system is used, as a substrate of 152 mm square and 6.35 mm thick.

The multilayer reflective film is a film reflecting exposure light which is extreme ultraviolet region light. The multilayer reflective film is preferably formed in contact with the substrate. The extreme ultraviolet region light is called EUV light. The EUV light has a wavelength of 13 to 14 nm, and is usually light having a wavelength of about 13.5 nm.

The material for forming the multilayer reflective film is preferably a material having resistance to dry etching (chlorine-based dry etching) using a chlorine-based gas (for example, chlorine gas (Cl₂ gas) alone or a mixed gas of chlorine gas (Cl₂ gas) and oxygen gas (O₂ gas)).

Specific examples of the material for forming the multilayer reflective film include silicon (Si) and molybdenum (Mo). As the multilayer reflective film, a laminated film (Si/Mo laminated film) consisting of about 20 to 60 layers obtained by alternately stacking silicon (Si) layers and molybdenum (Mo) layers is commonly used.

The thickness of the multilayer reflective film is preferably 200 nm or more, more preferably 220 nm or more, and is preferably 340 nm or less, more preferably 280 nm or less. The thickness of the silicon (Si) layer is preferably 2 nm or more, more preferably 3 nm or more, and is preferably 6 nm or less, more preferably 5 nm or less. The thickness of the molybdenum (Mo) layer is preferably 1 nm or more, more preferably 2 nm or more, and is preferably 5 nm or less, more preferably 4 nm or less.

The protective film is a film for protecting the multilayer reflective film. The protective film is preferably formed in contact with the multilayer reflective film. The protective film is provided for protecting the multilayer reflective film, for example, in cleaning in processing from the reflective photomask blank to the reflective photomask, cleaning and correction of the reflective photomask. Furthermore, the protective film preferably has a function of protecting the multilayer reflective film when the light-absorbing film is patterned by etching, and a function of preventing oxidation of the multilayer reflective film.

The material for forming the protective film is preferably a material different in etching characteristic from the light-absorbing film, and specifically preferably a material having resistance to dry etching using fluorine-based gas (SF₆ gas, CF₄ gas, etc.), for example, dry etching(fluorine-based dry etching) using a mixed gas of an SF₆ gas and a helium gas (He gas), and dry etching (chlorine-based dry etching) using a chlorine-based gas (for example, chlorine gas (Cl₂ gas) alone or a mixed gas of chlorine gas (Cl₂ gas) and oxygen gas (O₂ gas)). Furthermore, the material for forming the protective film is preferably a material having resistance to a cleaning liquid containing sulfuric acid or a cleaning liquid containing an alkali.

Specific examples of the material for forming the protective film include a material containing rhodium (Rh). The material for forming the protective film preferably has resistance to fluorine-based dry etching, chlorine-based dry etching, and dry etching performed by activating a fluorine-based gas with an electron beam. From this viewpoint, the material for forming the protective film is more preferably rhodium (Rh) alone.

The protective film may be a single-layer film or a multilayer film (for example, a film constituted of 2 to 4 layers). Furthermore, the protective film may be a film having a gradient composition. The thinner the thickness of the protective film, the higher the reflectance of the exposure light from the multilayer reflective film of the reflective photomask. In the exposure using the reflective photomask, a larger amount of exposure light is applied to the wafer and the productivity in the exposure using the reflective photomask is improved. In contrast, if the thickness is too thin, the protective film loses the function of protecting the multilayer reflective film. Because of this, the thickness of the protective film is preferably 1 nm or more, and preferably 6 nm or less, more preferably 4 nm or less.

The light-absorbing film is a film absorbing exposure light which is extreme ultraviolet region light. The light-absorbing film and the pattern of the light-absorbing film are preferably formed in contact with the protective film.

The material for forming the light-absorbing film is preferably a material that can be etched by dry etching (fluorine-based dry etching) using fluorine-based gas (SF₆ gas, CF₄ gas, etc.), for example, dry etching using a mixed gas of SF₆ gas and helium gas (He gas). Furthermore, the material for forming the light-absorbing film is preferably a material having resistance to dry etching (chlorine-based dry etching) using a chlorine-based gas (for example, chlorine gas (Cl₂ gas) alone or a mixed gas of chlorine gas (Cl₂ gas) and oxygen gas (O₂ gas)).

Specific examples of such a material include a material containing platinum (Pt) and ruthenium (Ru). The light-absorbing film is preferably formed only of a material containing platinum (Pt) and ruthenium (Ru). Specific examples of the material containing platinum (Pt) and ruthenium (Ru) include platinum ruthenium (PtRu).

The light-absorbing film may be formed of a material containing platinum (Pt) and ruthenium (Ru) alone, or may be formed of a material containing another element as well as platinum (Pt) and ruthenium (Ru). In the case, in the light-absorbing film, the total content of platinum (Pt) and ruthenium (Ru) is preferably 96 atomic % or more as an overall average in the light-absorbing film. Examples of the element other than platinum (Pt) and ruthenium (Ru) include metal elements such as niobium (Nb), and light elements such as oxygen (O), nitrogen (N), carbon (C), and boron (B).

In the light-absorbing film, the content of platinum (Pt) is 40 atomic % or more, preferably 42 atomic % or more, and 60 atomic % or less, preferably less than 60%, and more preferably 48 atomic % or less, as an overall average in the light-absorbing film. Furthermore, in the light-absorbing film, the content of ruthenium (Ru) is 40 atomic % or more, preferably more than 40 atomic %, more preferably 52 atomic % or more, and 60 atomic % or less, preferably 58 atomic % or less, as an overall average in the light-absorbing film. The light-absorbing film preferably has an extinction coefficient k of 0.05 or less, as an overall average in the light-absorbing film, from the viewpoint of achieving a reflectance with respect to the exposure light of a predetermined value or more, particularly a reflectance with respect to the exposure light of 3% or more.

When the reflective photomask is produced from the reflective photomask blank, the light-absorbing film is exposed to cleaning with sulfuric acid or cleaning with an alkali in a cleaning step. Furthermore, the reflective photomask is exposed to the atmosphere in a storage environment or an environment where a wafer exposure machine is used. Because of this, the higher content of platinum (Pt) than the content of ruthenium (Ru), particularly highest content of platinum (Pt) on the side of the light-absorbing film farthest from the substrate is advantageous in view of cleaning resistance, and is also advantageous in view of oxidation resistance. In the present invention, the content of platinum (Pt) on the side of the light-absorbing film farthest from the substrate is preferably 50 atomic % or more, more preferably more than 50 atomic %, and still more preferably 52 atomic % or more, and is preferably 90 atomic % or less, more preferably 70 atomic % or less, and still more preferably 60 atomic % or less.

In contrast, since the extinction coefficient k of platinum (Pt) is larger than the extinction coefficient k of ruthenium (Ru), if the content of platinum (Pt) in the entire light-absorbing film is too high, the reflectance with respect to the exposure light decreases. Because of this, from the viewpoint of obtaining a predetermined value or more of reflectance with respect to the exposure light, particularly a reflectance with respect to the exposure light of 3% or more, it is effective that the content of platinum (Pt) intermittently or continuously decreases in part or whole of the light-absorbing film along the thickness direction thereof from the side of the light-absorbing film farthest from the substrate toward the substrate side. In this case, the content of ruthenium (Ru) may be constant in part or whole of the light-absorbing film along the thickness direction thereof from the side of the light-absorbing film farthest from the substrate toward the substrate side, but it is preferable that the content intermittently or continuously increases in part or whole of the light-absorbing film along the thickness direction thereof.

Examples of the change in platinum (Pt) content along the thickness direction of the light-absorbing film include,
a change where the content is constant partway from the side of the light-absorbing film farthest from the substrate toward the substrate side, and then continuously decreases toward the substrate side up to the side closest to the substrate,
a change where the content continuously decreases partway from the side of the light-absorbing film farthest from the substrate toward the substrate side and becomes constant from, for example, a central part, particularly, the center, of the light-absorbing film in the thickness direction up to the side closest to the substrate,
a change where the content continuously decreases partway from the side of the light-absorbing film farthest from the substrate toward the substrate side, once becomes constant and continuously decreases again toward the substrate side up to the side closest to the substrate, and
a change where the content continuously decreases from the side of the light-absorbing film farthest from the substrate toward the substrate side up to the side closest to the substrate.

Examples of the change in ruthenium (Ru) content along the thickness direction of the light-absorbing film include,
a change where the content is constant partway from the side of the light-absorbing film farthest from the substrate toward the substrate side, and then continuously increases toward the substrate side up to the side closest to the substrate,
a change where the content continuously increases partway from the side of the light-absorbing film farthest from the substrate toward the substrate side and becomes constant from, for example, a central part, particularly, the center, of the light-absorbing film in the thickness direction up to the side closest to the substrate,
a change where the content continuously increases partway from the side of the light-absorbing film farthest from the substrate toward the substrate side, once becomes constant and continuously increases again toward the substrate side up to the side closest to the substrate, and
a change where the content continuously increases from the side of the light-absorbing film farthest from the substrate toward the substrate side up to the side closest to the substrate.

Note that, if the light-absorbing film contains the other element as well as platinum (Pt) and ruthenium (Ru), the content of the other element may be constant or may intermittently or continuously increase or decrease in part or whole of the light-absorbing film along the thickness direction thereof from the side of the light-absorbing film farthest from the substrate toward the substrate side.

In the present invention, the content of platinum (Pt) on the side of the light-absorbing film closest to the substrate is preferably 40 atomic % or more, more preferably 42 atomic % or more, and preferably 50 atomic % or less, more preferably 48 atomic % or less. Furthermore, the content of ruthenium (Ru) on the side of the light-absorbing film closest to the substrate is preferably 50 atomic % or more, more preferably 52 atomic % or more, and preferably 60 atomic % or less, more preferably 58 atomic % or less.

In the present invention, the content of platinum (Pt) in the center of the light-absorbing film in the thickness direction is preferably 40 atomic % or more, more preferably 42 atomic % or more, and preferably 56 atomic % or less, more preferably 50 atomic % or less, and still more preferably 48 atomic % or less. Furthermore, the content of ruthenium (Ru) in the center of the light-absorbing film in the thickness direction is preferably 44 atomic % or more, more preferably 50 atomic % or more, still more preferably 52 atomic % or more, and preferably 60 atomic % or less, more preferably 58 atomic % or less.

After the light-absorbing film of the reflective photomask blank is patterned, if the pattern of the light-absorbing film fails to have a desired shape, correction is made. For the correction of reflective photomask, principally electron beam correction is used since the processing accuracy of the photomask pattern is satisfactory. A fluorine-based gas such as a xenon fluoride gas (XeF₂) is used for electron beam correction of the light-absorbing film formed of a material containing platinum (Pt) and ruthenium (Ru). The pattern of the light-absorbing film can be corrected by processing a micro-region by dry etching performed by activating the fluorine-based gas with an electron beam. The light-absorbing film is preferably formed of a material that can be corrected only by dry etching performed by activating a fluorine-based gas with an electron beam.

When the pattern of the light-absorbing film is corrected, if the pattern of the light-absorbing film is completely etched, the etching reaches the protective film. However, in this situation, if the protective film is also etched, the function of the protective film is impaired in the reflective photomask. Because of this, when the protective film and the light-absorbing film are etched by dry etching performed by activating a fluorine-based gas with an electron beam under the same conditions, the ratio (selectivity) of the etching rate of the light-absorbing film to the etching rate of the protective film is preferably 50 or more, more preferably 70 or more, and still more preferably 100 or more. When the ratio (selectivity) of the etching rates is 50 or more, the success rate of pattern correction of the light-absorbing film by dry etching performed by activating a fluorine-based gas with an electron beam is improved.

Furthermore, the light-absorbing film preferably has a structure that can be corrected only by dry etching performed by activating a fluorine-based gas with an electron beam. For example, when the light-absorbing film is a multilayer formed of two or more materials different in etching characteristic, it is necessary to apply two or more different types of etching in forming and correcting the pattern of the light-absorbing film. As a result, a stepped portion is likely to appear in the cross section of the pattern of the light-absorbing film. If the pattern of the light-absorbing film has a stepped portion, the possibility of having inaccuracies or errors increases when a pattern is transferred. Thus, such a stepped pattern fails to deal with miniaturization of the pattern. In the cross section of the pattern of the light-absorbing film, from the viewpoint of preventing formation of a stepped portion and from the viewpoint of obtaining a shape that is more perpendicular to the main surface of the substrate, the light-absorbing film is formed only of preferably a material containing platinum (Pt) and ruthenium (Ru), more preferably a material containing platinum (Pt) and ruthenium (Ru) at a content of 96 atomic % or more in total of platinum (Pt) and ruthenium (Ru), still more preferably a material consisting of platinum (Pt) and ruthenium (Ru).

In the present invention, the light-absorbing film is a film having a phase shift function, that is, a phase-shift film. The light-absorbing film having a phase shift function is a film that absorbs a part of exposure light and reflects the rest of the exposure light by changing (shifting) its phase relative to the phase of the exposure light reflected from the multilayer reflective film, thereby obtaining a phase shift function by a phase difference between light reflected from the multilayer reflective film and light reflected from the light-absorbing film.

The reflective photomask blank and reflective photomask of the present invention can be referred to as a reflective photomask blank having a phase shift function (reflective phase-shift photomask blank) and a reflective photomask having a phase shift function (reflective phase-shift photomask), respectively.

The light-absorbing film having a phase shift function (phase-shift film) has a reflectance of preferably 3% or more, more preferably 4% or more, and preferably 10% or less, more preferably 8% or less with respect to the exposure light which is extreme ultraviolet region light. This reflectance is a relative reflectance to that of a portion where the light-absorbing film is not formed, and specifically, is a ratio of the reflectance of light reflected from the light-absorbing film formed on the substrate via the multilayer reflective film and the protective film relative to the reflectance of light reflected from the multilayer reflective film and the protective film formed on the substrate.

The light-absorbing film having a phase shift function (phase-shift film) has a phase difference of preferably 200 degrees or more, more preferably 205 degrees or more, and preferably 230 degrees or less, more preferably 225 degrees or less with respect to exposure light which is extreme ultraviolet region light. This phase difference is a relative phase difference to a portion where the light-absorbing film is not formed, and specifically, is a difference between a phase of light reflected from the multilayer reflective film and the protective film formed on the substrate and a phase of light reflected from the light-absorbing film formed on the substrate via the multilayer reflective film and the protective film.

The thickness of the light-absorbing film is preferably 35 nm or more, more preferably 36 nm or more, and preferably 40 nm or less, more preferably 38 nm or less from the viewpoint of ensuring the light absorption function and the phase shift function and reducing the influence of the shadowing effect.

The light-absorbing film is exposed to cleaning with sulfuric acid or cleaning with an alkali in the production process for the reflective photomask, and the pattern of the light-absorbing film is exposed to cleaning with sulfuric acid or cleaning with an alkali when the reflective photomask is used or also when the pattern is corrected. When the light-absorbing film of the present invention comes into contact with an aqueous solution containing sulfuric acid, such as a sulfuric acid-hydrogen peroxide mixture (SPM), specifically, when cleaning (100°C, 30 min) is performed with a sulfuric acid-hydrogen peroxide mixture (mixed solution of sulfuric acid: hydrogen peroxide = 3: 1 (volume ratio)), the change in the thickness of the light-absorbing film is preferably 0.5 nm or less, more preferably 0.3 nm or less. Furthermore, when the light-absorbing film of the present invention comes into contact with an aqueous solution containing an alkali, specifically, when cleaning (80°C, 50 min) is performed with an aqueous alkali solution (ammonia, H₂SO₄ concentration: 6000 ppm), the change in the thickness of the light-absorbing film is preferably 0.5 nm or less, more preferably 0.3 nm or less.

The hard mask film is a film functioning as an etching mask in etching of the light-absorbing film. The hard mask film is usually formed in contact with the light-absorbing film. The hard mask film may be composed of a single layer or a multilayer (for example, 2 to 5 layers). Furthermore, the hard mask film may be a film having a gradient composition.

The hard mask film preferably functions as an etching mask when the light-absorbing film is patterned by dry etching using a fluorine-based gas. The hard mask film is preferably formed of a material having resistance to dry etching (fluorine-based dry etching) using fluorine-based gas (SF₆ gas, CF₄ gas, etc.), for example, dry etching using a mixed gas of SF₆ gas and helium gas (He gas). Furthermore, the hard mask film is preferably formed of a material that can be etched by dry etching (chlorine-based dry etching) using a chlorine-based gas (for example, chlorine gas (Cl₂ gas) alone or a mixed gas of chlorine gas (Cl₂ gas) and oxygen gas (O₂ gas)), particularly dry etching using a mixed gas of chlorine gas (Cl₂ gas) and oxygen gas (O₂ gas).

The material for forming the hard mask film is preferably a material containing chromium (Cr). The material for forming the hard mask film preferably contains neither platinum (Pt) nor ruthenium (Ru). The material for forming the hard mask film may contain one or more light elements selected from oxygen (O), nitrogen (N), carbon (C), and boron (B). Specific examples of the material for the hard mask film include chromium oxide (CrO), chromium nitride (CrN), chromium oxynitride (CrON), chromium carbide (CrC), chromium oxycarbide (CrCO), chromium carbonitride (CrCN), and chromium oxynitride carbide (CrONC).

If the hard mask film is too thin, the film may lose a function as an etching mask in etching of the light-absorbing film, and the defect inspection sensitivity of the hard mask film may be reduced. Because of this, the thickness of the hard mask film is preferably 2 nm or more, more preferably 4 nm or more. Furthermore, when the hard mask film is removed by dry etching, usually the protective film is also simultaneously exposed to dry etching. In this case, if the hard mask film is too thick, an amount of loss of the protective film increases. Because of this, the thickness of the hard mask film is preferably 14 nm or less, more preferably 10 nm or less.

The conductive film is preferably formed in contact with the substrate. The conductive film preferably has a sheet resistance of 100 Ω/square or less, and the material therefor is not particularly limited. Examples of the material for the conductive film include a material containing tantalum (Ta) or chromium (Cr). Furthermore, the material containing tantalum (Ta) or chromium (Cr) may contain one or more light elements selected from oxygen (O), nitrogen (N), carbon (C), and boron (B). The thickness of the conductive film is not particularly limited as long as the conductive film functions as an electrostatic chuck, but is usually about 20 to 300 nm.

The resist film is preferably formed in contact with the light-absorbing film or the hard mask film. In the present invention, the resist film may be an electron beam resist drawn by an electron beam or a photoresist drawn by light, but is preferably a chemically amplified resist. The chemically amplified resist may be a positive-type or a negative-type resist. Examples of the chemically amplified resist include a resist containing a base resin such as a hydroxystyrene resin or a (meth)acrylic acid resin, and an acid generator, and, if necessary, e.g., a crosslinking agent, a quencher and/or a surfactant.

The thickness of the resist film is preferably 150 nm or less. From the viewpoint of making a resist pattern for forming a fine assist pattern difficult to collapse caused by impact of a developing fluid or impact of pure water during the rinse process in the development step of forming the resist pattern, the thickness is preferably 100 nm or less. The lower limit of the resist film in thickness is not limited as long as the film has a thickness enough to function as an etching mask during etching, that is, enough to leave a resist pattern over the entire surface of the film to be etched after etching. The thickness is not particularly limited, but preferably 50 nm or more, more preferably 70 nm or more.

The formation of the multilayer reflective film, protective film, light-absorbing film, hard mask film, and conductive film of the present invention is not particularly limited, but formation by a sputtering method is preferable because a film having predetermined characteristics is easily formed with good controllability. Examples of sputtering system that can be applied include, but are not limited to, DC sputtering and RF sputtering.

When a laminated film of molybdenum (Mo) layers and silicon (Si) layers is formed as the multilayer reflective film, a molybdenum (Mo) target and a silicon (Si) target can be used as the sputtering targets.

When the protective film is formed of a material containing rhodium (Rh), a rhodium (Rh) target can be used as the sputtering target.

When the light-absorbing film is formed of a material containing platinum (Pt) and ruthenium (Ru), a platinum (Pt) target and a ruthenium (Ru) target can be used as the sputtering targets, and, if necessary, a niobium (Nb) target can be used.

When the hard mask film is formed of a material containing chromium (Cr), a chromium (Cr) target can be used as the sputtering target.

When the conductive film is formed of a material containing tantalum (Ta) or chromium (Cr), a tantalum (Ta) target or a chromium (Cr) target can be used as the sputtering target.

The electric power to be supplied to a sputtering target may be appropriately set depending on, e.g., the size of the sputtering target, cooling efficiency, and controllability of forming a film. Usually, the electric power per area of the sputtering surface of the sputtering target may be set to 50 to 3000 W/cm². Furthermore, as the sputtering gas, a rare gas such as helium gas (He gas), neon gas (Ne gas), or argon gas (Ar gas) is used.

In a case where a film (layer constituting a film) is formed only of the element of a target, a rare gas alone may be used as the sputtering gas.

When a film (layer constituting a film) is formed of a material containing one or more light elements selected from oxygen (O), nitrogen (N), and carbon (C), reactive sputtering is preferable as the sputtering. As a sputtering gas for reactive sputtering, a rare gas such as helium gas (He gas), neon gas (Ne gas), or argon gas (Ar gas), and a reactive gas are used.

When a film (layer constituting a film) is formed of a material containing oxygen (O), oxygen gas (O₂ gas) may be used as the reactive gas. When a film (layer constituting a film) is formed of a material containing nitrogen (N), nitrogen gas (N₂ gas) may be used as the reactive gas. When a film (layer constituting a film) is formed of a material containing nitrogen (N) and oxygen (O), the reactive gas may be appropriately selected from oxygen gas (O₂ gas), nitrogen gas (N₂ gas), and a nitrogen oxide gas such as nitrogen monoxide gas (NO gas), nitrogen dioxide gas (NO₂ gas), or nitrous oxide gas (N₂O gas) and used. When a film (layer constituting the film) is formed of a material containing carbon, a carbon-containing gas such as methane gas (CH₄), carbon monoxide gas (CO gas), or carbon dioxide gas (CO₂ gas) may be used as the reactive gas. For example, when a film (layer constituting a film) is formed of a material containing nitrogen (N), oxygen (O), and carbon (C), for example, oxygen gas (O₂ gas), nitrogen gas (N₂ gas), and carbon dioxide gas (CO₂) may be used simultaneously as the reactive gases.

Furthermore, when a film is formed of a material containing boron (B), a target to which boron (B) is added can be used.

The pressure when a film (layer constituting a film) is formed may be appropriately set in consideration of, e.g., film stress, chemical resistance, and cleaning resistance. The pressure is preferably 0.01 Pa or more, more preferably 0.03 Pa or more, and preferably 1 Pa or less, more preferably 0.3 Pa or less to particularly improve the chemical resistance. Furthermore, each of the gas flow rates may be appropriately set so as to provide a desired composition, and may be usually 0.1 to 100 sccm.

In the production process for the reflective photomask blank, before a resist film is formed, a substrate or a substrate and a film formed on the substrate may be subjected to heat treatment. When the heat treatment is performed, it is preferable that heat treatment is applied in a state where the surface of the light-absorbing film is not exposed. As a method for the heat treatment, e.g., infrared heating or resistance heating can be applied, and the conditions for the treatment are not particularly limited. The heat treatment can be performed, for example, in a gas atmosphere containing oxygen (O). The concentration of the gas containing oxygen (O) is not particularly limited. In the case of oxygen gas (O₂ gas), the content of the gas can be, for example, 1 to 100 vol%. The temperature of the heat treatment is preferably 200°C or more, more preferably 400°C or more.

Furthermore, in the production process for a reflective photomask blank, before a resist film is formed, a film formed on a substrate except a light-absorbing film may be subjected to, e.g., treatment with ozone, or treatment with plasma. The conditions for the treatment are not particularly limited. Any treatment can be applied for the purpose of increasing the oxygen concentration of the surface portion of the film. In the case, the treatment conditions may be appropriately controlled so as to obtain a predetermined oxygen concentration. Note that, when the film is formed by sputtering, the oxygen concentration of the surface portion of the film can be increased by controlling the ratio of a rare gas to an oxygen containing gas (oxidizing gas) such as oxygen gas (O₂ gas), carbon monoxide gas (CO gas), or carbon dioxide gas (CO₂ gas) in the sputtering gas.

Further, in the production process for the reflective photomask blank, before the resist film is formed, cleaning treatment may be performed to remove defects present on a substrate or the surface of a film formed on the substrate. The cleaning can be performed using one or both of ultrapure water and a functional water that is ultrapure water containing, e.g., ozone gas (O₃ gas) or hydrogen gas (H₂ gas). When the cleaning treatment is applied to the light-absorbing film, it is preferable that the functional water containing ozone gas (O₃ gas) is not used. Furthermore, after cleaning with ultrapure water containing a surfactant, cleaning may be further performed using one or both of ultrapure water and the functional water. If necessary, the cleaning can be performed while applying ultrasonic waves, or combining UV light irradiation.

The method for forming a resist film (coating a resist) is not particularly limited, and a known method such as spin coating can be applied.

A reflective photomask having a substrate, a multilayer reflective film, a protective film, and a pattern of a light-absorbing film can be produced from the reflective photomask blank of the present invention.

In the production of the reflective photomask, in a case where the resist film is not formed on the reflective photomask blank, the resist film is formed in contact with a film farthest from the substrate of the reflective photomask blank, for example, the side of the light-absorbing film or the hard mask film farthest from the substrate.

Thereafter, using a resist pattern obtained by patterning a resist film or a film pattern obtained by patterning a film such as a hard mask film, as an etching mask, dry etching, which is appropriately selected from, e.g., chlorine-based dry etching and fluorine-based dry etching according to the etching characteristic of a material for forming each film, is applied to pattern or remove the film. In this manner, a reflective photomask can be produced. In the production of the reflective photomask, the resist pattern can be removed with a sulfuric acid-hydrogen peroxide mixture (SPM).

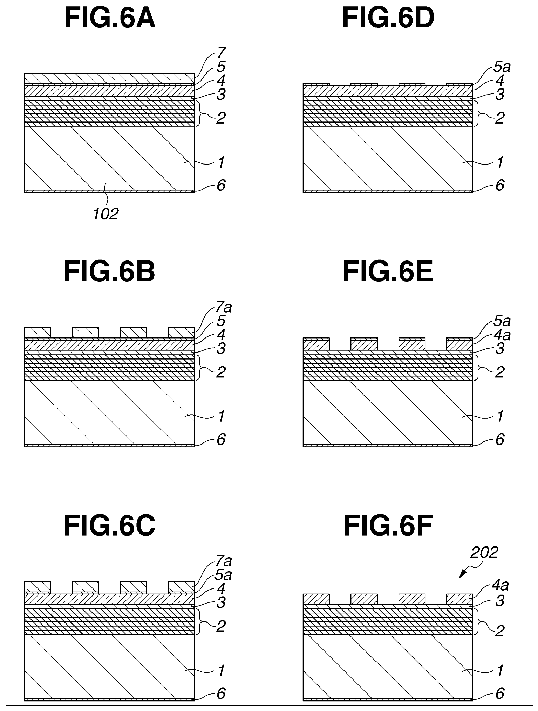

Next, referring to the drawings, an example of a method for producing a reflective photomask from the reflective photomask blank of the present invention is specifically described. FIG. 6 includes cross-sectional views for explaining steps of producing the reflective photomask according to the second aspect of the present invention from the reflective photomask blank according to the second aspect of the present invention.

First, as illustrated in FIG. 6(A), the resist film 7 is formed in contact with the side of the hard mask film 5 of the reflective photomask blank 102 farthest from the substrate (step (A)).

Subsequently, as illustrated in FIG. 6(B), the resist film 7 is patterned to form a resist pattern 7a (step (B)).

Subsequently, as illustrated in FIG. 6(C), the hard mask film 5 is patterned by dry etching using a chlorine-based gas with the resist pattern 7a used as an etching mask to form a pattern 5a of the hard mask film (step (C)).

Subsequently, as illustrated in FIG. 6(D), the resist pattern 7a is removed (step (D)).

Subsequently, as illustrated in FIG. 6(E), the light-absorbing film 4 is patterned by dry etching using a fluorine-based gas with the pattern 5a of the hard mask film used as an etching mask to form a pattern 4a of the light-absorbing film (step (E)).

Next, as illustrated in FIG. 6(F), the pattern 5a of the hard mask film is removed by dry etching using a chlorine-based gas (step (F)) to obtain the reflective photomask 202.

### EXAMPLES

Hereinafter, the present invention is specifically described with reference to Examples and Comparative Examples, but the present invention is not limited to the following Examples.

### Examples 1 to 13, Comparative Examples 1 to 3

A multilayer reflective film, a protective film, a light-absorbing film, and a hard mask film were sequentially stacked on one of the main surfaces of a 152 mm-square and about 6 mm-thick quartz substrate, and a conductive film was formed on the other main surface of the quartz substrate to produce a reflective photomask blank (reflective photomask blank of the second aspect), as illustrated in FIG. 2.

First, using a molybdenum (Mo) target and a silicon (Si) target as targets, and argon gas (Ar gas) as a sputtering gas, sputtering from the molybdenum (Mo) target and sputtering from the silicon (Si) target were alternately performed by controlling the electric powers to be applied to the targets and controlling the flow rate of the sputtering gas to form a laminated film (thickness: 280 nm) in which molybdenum (Mo) layers and silicon (Si) layers were alternately stacked on the quartz substrate (one of the main surfaces), that is, the multilayer reflective film (reflectance with respect to light of 13.5 nm in wavelength: 65%). A cycle consisting of stacking the molybdenum (Mo) layer and the silicon (Si) layer was repeated 40 cycles (the numbers of molybdenum (Mo) layers and silicon (Si) layers were each 40).

Subsequently, using a rhodium (Rh) target as a target, and argon gas (Ar gas) as a sputtering gas, sputtering was performed by controlling the electric power to be applied to the target and controlling the flow rate of the sputtering gas to form the protective film, that is, a film (thickness: 2 nm) formed of rhodium (Rh) alone, on the multilayer reflective film.

Subsequently, using a tantalum (Ta) target as a target, and argon gas (Ar gas) and nitrogen gas (N₂ gas) as sputtering gases, sputtering was performed by controlling the electric power to be applied to the target and controlling the flow rates of the sputtering gases to form the conductive film, that is, a film (thickness: 70 nm) formed of tantalum nitride (TaN), on the quartz substrate (the other main surface).

Subsequently, using a platinum (Pt) target and a ruthenium (Ru) target as targets, and argon gas (Ar gas) as a sputtering gas, sputtering was performed by controlling the electric powers to be applied to the targets and controlling the flow rate of the sputtering gas to form the light-absorbing film having a phase shift function, that is, a film formed of platinum ruthenium (PtRu), on the protective film.

By changing the power to be applied to each target with time, the light-absorbing film has
a composition change in which the platinum (Pt) content continuously decreases and the ruthenium (Ru) content continuously increases along the thickness direction of the light-absorbing film from the side of the light-absorbing film farthest from the substrate toward the substrate side, and the platinum (Pt) content and ruthenium (Ru) content becomes constant from the center of the thickness direction of the light-absorbing film up to the side closest to the substrate, or
a composition change in which the platinum (Pt) content continuously decreases and the ruthenium (Ru) content continuously increases along the thickness direction of the light-absorbing film from the side of the light-absorbing film farthest from the substrate up to the side closest to the substrate side.

Subsequently, using a chromium (Cr) target as a target, and using argon gas (Ar gas), oxygen gas (O₂ gas), nitrogen gas (N₂ gas), and carbon dioxide gas (CO₂ gas) as sputtering gases, sputtering was performed by controlling the electric power to be applied to the target and controlling the flow rates of the sputtering gases to form the hard mask film, that is, a film (thickness: 10 nm, chromium (Cr) content: 38 atomic %, oxygen (O) content: 34 atomic %, nitrogen (N) content: 18 atomic %, and carbon (C) content: 10 atomic %) formed of chromium oxynitride carbide (CrONC) on the light-absorbing film.

In this manner, a reflective photomask blank was obtained.

### Comparative Examples 4 and 5

A reflective photomask blank was obtained in the same manner as in Example 1 except that, in the formation of the light-absorbing film having a phase shift function, the electric powers to be applied to respective targets were not changed with time to form the light-absorbing film having a phase shift function with the composition in which the content of platinum (Pt) and the content of ruthenium (Ru) were constant from the side of the light-absorbing film farthest from the substrate up to the side closest to the substrate along the thickness direction of the light-absorbing film, that is, without compositional change.

### Comparative Example 6

A reflective photomask blank was obtained in the same manner as in Example 1 except that, in the formation of the protective film, using a ruthenium (Ru) target and a niobium (Nb) target as targets, and argon gas (Ar gas) as a sputtering gas, sputtering was performed by controlling the electric powers to be applied to the targets and controlling the flow rate of the sputtering gas to form the protective film, that is, a film (thickness: 2 nm) formed of ruthenium niobium (RuNb) on the multilayer reflective film.

With respect to each reflective photomask blank, the compositions (average of the entire film, the side of the film farthest from the substrate (upper side), the center in the thickness direction (center), the side of the film closest to substrate (lower side)) and thickness, and with respect to light having a wavelength of 13.5 nm, the reflectance (relative reflectance with respect to the multilayer reflective film and the protective film) and the phase difference (relative phase difference with respect to the multilayer reflective film and the protective film) of the light-absorbing film are shown in Table 1. Note that, the composition of the light-absorbing film was measured by an X-ray photoelectron spectrometer. Furthermore, the thickness of the light-absorbing film was measured by an X-ray reflectance method using an X-ray diffractometer (the same applies to the following measurement of the thickness of the film). As the reflectance, the reflectance with respect to light having an incident angle of 6 degrees was measured by a reflectometer. Furthermore, the refractive index n and the extinction coefficient k were measured by a refractive index/extinction coefficient measuring device, and the phase difference was calculated from these measured values.

**Table 1**

| | | Composition [atomic%] | | | | | | | | Thickness [nm] | Reflectance [%] | Phase difference [degrees] |
|---|---|---|---|---|---|---|---|---|---|---|---|---|
| | | Average | | Upper side | | Center | | Lower side | | | | |
| | | Pt | Ru | Pt | Ru | Pt | Ru | Pt | Ru | | | |
| | 1 | 48 | 52 | 55 | 45 | 45 | 55 | 45 | 55 | 37.0 | 3.4 | 216.1 |
| | 2 | 49 | 51 | 55 | 45 | 47 | 53 | 45 | 55 | 37.0 | 3.3 | 216.1 |
| | 3 | 50 | 50 | 55 | 45 | 50 | 50 | 45 | 55 | 37.0 | 3.2 | 216.0 |
| | 4 | 51 | 49 | 55 | 45 | 53 | 47 | 45 | 55 | 37.0 | 3.1 | 215.9 |
| | 5 | 52 | 48 | 55 | 45 | 55 | 45 | 45 | 55 | 37.0 | 3.0 | 215.8 |
| | 6 | 48 | 52 | 53 | 47 | 45 | 55 | 45 | 55 | 38.0 | 5.3 | 212.1 |
| Example | 7 | 48 | 52 | 55 | 45 | 45 | 55 | 45 | 55 | 39.0 | 8.1 | 229.8 |
| | 8 | 48 | 52 | 55 | 45 | 45 | 55 | 45 | 55 | 35.1 | 6.1 | 229.6 |
| | 9 | 48 | 52 | 55 | 45 | 45 | 55 | 45 | 55 | 36.0 | 4.2 | 229.7 |
| | 10 | 59 | 41 | 89 | 11 | 56 | 44 | 50 | 50 | 35.4 | 3.0 | 227.3 |
| | 11 | 50 | 50 | 56 | 44 | 55 | 45 | 40 | 60 | 36.4 | 3.5 | 220.4 |
| | 12 | 50 | 50 | 52 | 48 | 50 | 50 | 49 | 51 | 37.1 | 3.2 | 210.1 |
| | 13 | 50 | 50 | 59 | 41 | 50 | 50 | 40 | 60 | 37.4 | 3.5 | 217.8 |
| Comparative Example | 1 | 45 | 55 | 61 | 39 | 52 | 48 | 45 | 55 | 36.0 | 2.5 | 203.4 |
| | 2 | 58 | 42 | 55 | 45 | 45 | 55 | 45 | 55 | 34.0 | 6.7 | 232.4 |
| | 3 | 61 | 39 | 91 | 9 | 59 | 41 | 45 | 55 | 40.2 | 8.9 | 240.1 |
| | 4 | 48 | 52 | 45 | 55 | 45 | 55 | 45 | 55 | 38.0 | 5.7 | 213.7 |
| | 5 | 48 | 52 | 58 | 42 | 58 | 42 | 58 | 42 | 38.0 | 2.9 | 206.4 |
| | 6 | 48 | 52 | 55 | 45 | 45 | 55 | 45 | 55 | 38.0 | 5.2 | 211.7 |

Next, using the obtained reflective photomask blank, a reflective photomask (reflective photomask of the second aspect) illustrated in FIG. 5 was produced.

First, a positive-type chemically amplified electron beam resist was spin-coated on the hard mask film to form a resist film of 150 nm in thickness (step (A)).

Subsequently, a line-and-space pattern (long-side dimension: 1000 nm, the number of line patterns: 100,000) was drawn at a dose of 100 µC/cm² using an electron beam drawing device. The widths of the line pattern and the space pattern were each 100 nm. Subsequently, heat treatment (PEB: Post Exposure Bake) was performed at 110°C for 14 minutes using a heat treatment apparatus. Subsequently, a development process was performed by puddle development for 40 seconds to form a resist pattern (step (B)).

Subsequently, using the obtained resist pattern as an etching mask, the hard mask film was dry etched by using a chlorine-based gas under the following conditions to form a pattern of the hard mask film (step (C)).

### <Conditions of Dry Etching Using Chlorine-based Gas>

| | |
|---|---|
| Apparatus: | ICP (Inductively Coupled Plasma) system |
| Etching gas: | Cl₂ gas and O₂ gas |
| Gas pressure: | 3.0 mTorr (0.40 Pa) |
| ICP power: | 350 W |

Subsequently, the remaining resist pattern was removed by cleaning with a sulfuric acid-hydrogen peroxide mixture (mixed solution of sulfuric acid and hydrogen peroxide solution (sulfuric acid: hydrogen peroxide solution = 3: 1 (volume ratio))) (step (D)).

Subsequently, using the obtained pattern of the hard mask film as an etching mask, dry etching using a fluorine-based gas was applied under the following conditions to form a pattern of the light-absorbing film (step (E)).

### <Conditions of Dry Etching Using Fluorine-based Gas>

| | |
|---|---|
| Apparatus: | ICP (Inductively Coupled Plasma) system |
| Gas: | SF₆ gas + He gas |
| Gas pressure: | 4.0 mTorr (0.53 Pa) |
| ICP power: | 400 W |

Subsequently, dry etching using a chlorine-based gas was applied to the pattern of the hard mask film under the above conditions (step (F)), and the pattern of the hard mask film was removed to obtain a reflective photomask.

For each of the obtained reflective photomasks, the thickness of the pattern of the light-absorbing film was measured to obtain the difference (reduction amount before and after the production) from the thickness of the light-absorbing film of the reflective photomask blank. The results are shown in Table 2.

Subsequently, cleaning (100°C, 6 min) of the reflective photomask with a sulfuric acid-hydrogen peroxide mixture (mixed solution of sulfuric acid: hydrogen peroxide = 3: 1 (volume ratio)) was repeated five times. The thickness of the pattern of the light-absorbing film was measured to obtain the difference (decrease amount) between before and after cleaning with the sulfuric acid-hydrogen peroxide mixture. The results are shown in Table 2.

Subsequently, cleaning (80°C, 10 min) of the reflective photomask with an alkaline aqueous solution (ammonia, H₂SO₄ concentration: 6000 ppm) was repeated five times. The thickness of the pattern of the light-absorbing film was measured to obtain the difference (decrease amount) between before and after cleaning with the alkaline aqueous solution. The results are shown in Table 2.

Further, using each of the obtained reflective photomask, dry etching performed by activating a fluorine-based gas with an electron beam, which is used when correcting the pattern of the light-absorbing film of the reflective photomask, was applied to each of the light-absorbing film pattern and the protective film under the following conditions, and the etching amount (thickness) and the etching time were measured. The etching rate was calculated from them, and the ratio of the etching rate of the light-absorbing film to the etching rate of the protective film was calculated as the selectivity. The results are shown in Table 2.

### <Conditions of Dry Etching Performed by Activating Fluorine-based Gas with Electron Beam>

| | |
|---|---|
| Device: | Electron beam correction device (MeRiT manufactured by Carl Zeiss) |
| Gas: | XeF₂ gas |

**Table 2**

| | | Amount of decrease in thickness of light-absorbing film [nm] | | | Etching rate [nm/sec] | | Selectivity |
|---|---|---|---|---|---|---|---|
| | | Before and after production | Before and after cleaning with a sulfuric acid-hydrogen peroxide mixture | Before and after cleaning with alkali aqueous solution | Light-absorbing film | Protective film | |
| | 1 | 0.2 | 0.3 | 0.3 | 4.6 | 0.01 | 460 |
| | 2 | 0.2 | 0.3 | 0.3 | 4.3 | 0.01 | 430 |
| | 3 | 0.2 | 0.3 | 0.3 | 4.1 | 0.01 | 410 |
| | 4 | 0.2 | 0.3 | 0.3 | 3.9 | 0.01 | 390 |
| | 5 | 0.2 | 0.3 | 0.3 | 3.7 | 0.01 | 370 |
| | 6 | 0.2 | 0.4 | 0.4 | 4.7 | 0.01 | 470 |
| Example | 7 | 0.2 | 0.3 | 0.3 | 4.6 | 0.01 | 460 |
| | 8 | 0.2 | 0.3 | 0.3 | 4.6 | 0.01 | 460 |
| | 9 | 0.2 | 0.3 | 0.3 | 4.6 | 0.01 | 460 |
| | 10 | 0.1 | 0.1 | 0.1 | 2.8 | 0.01 | 280 |
| | 11 | 0.2 | 0.3 | 0.3 | 4.5 | 0.01 | 450 |
| | 12 | 0.2 | 0.4 | 0.4 | 4.6 | 0.01 | 460 |
| | 13 | 0.1 | 0.1 | 0.1 | 3.2 | 0.01 | 320 |
| Comparative Example | 1 | 0.2 | 0.1 | 0.1 | 2.6 | 0.01 | 260 |
| | 2 | 0.2 | 0.3 | 0.3 | 4.6 | 0.01 | 460 |
| | 3 | 0.2 | 0.3 | 0.3 | 4.6 | 0.01 | 460 |
| | 4 | 0.2 | 0.8 | 0.8 | 4.9 | 0.01 | 490 |
| | 5 | 0.2 | 0.2 | 0.2 | 3.1 | 0.01 | 310 |
| | 6 | 0.2 | 0.3 | 0.3 | 4.6 | 0.11 | 42 |

Note that, the present invention is not limited to the above embodiment. The above embodiment is an example, and anything having the same or substantially the same configuration and exhibiting the same or similar function and effect as the technical idea of the present invention is included in the technical scope of the present invention.

## Claims

1. A reflective photomask blank comprising a substrate, a multilayer reflective film formed on the substrate and reflecting exposure light which is extreme ultraviolet region light, a protective film formed on the multilayer reflective film for protecting the multilayer reflective film, and a light-absorbing film formed on the protective film in contact with the protective film, absorbing the exposure light, and having a phase shift function, wherein
the light-absorbing film has a thickness of 35 nm or more and 40 nm or less,
the light-absorbing film is formed of a material containing platinum (Pt) and ruthenium (Ru),
as an overall average in the light-absorbing film, a content of platinum (Pt) is 40 atomic % or more and less than 60%, a content of ruthenium (Ru) is more than 40 atomic % and 60 atomic % or less, and a total content of platinum (Pt) and ruthenium (Ru) is 96 atomic % or more,
a content of platinum (Pt) on the side of the light-absorbing film farthest from the substrate is more than 50 atomic % and 90 atomic % or less,
a content of platinum (Pt) intermittently or continuously decreases in part or whole of the light-absorbing film along the thickness direction thereof from the side of the light-absorbing film farthest from the substrate toward the substrate side, and
the light-absorbing film has a reflectance of 3% or more and 10% or less with respect to the exposure light and a phase difference of 200 degrees or more and 230 degrees or less with respect to the exposure light.

2. The reflective photomask blank according to claim 1, wherein a content of platinum (Pt) on the side of the light-absorbing film closest to the substrate is 40 atomic % or more and 50 atomic % or less.

3. The reflective photomask blank according to claim 1 or 2, wherein the content of platinum (Pt) on the side of the light-absorbing film farthest from the substrate is 52 atomic % or more.

4. The reflective photomask blank according to any one of claims 1 to 3, wherein, when the protective film and the light-absorbing film are etched under the same conditions by dry etching performed with activating a fluorine-based gas by an electron beam, a ratio of an etching rate of the light-absorbing film to an etching rate of the protective film is 50 or more.

5. The reflective photomask blank according to any one of claims 1 to 4, wherein the protective film is formed of a material containing rhodium (Rh).

6. The reflective photomask blank according to any one of claims 1 to 5, further comprising a hard mask film formed on the light-absorbing film in contact with the light-absorbing film.

7. The reflective photomask blank according to claim 6, wherein the hard mask film is formed of a material that has resistance to fluorine-based dry etching and can be etched by chlorine-based dry etching.

8. The reflective photomask blank according to claim 7, wherein the hard mask film is formed of a material containing chromium (Cr), and has a thickness of 2 nm or more and 14 nm or less.

9. A reflective photomask comprising a substrate, a multilayer reflective film formed on the substrate and reflecting exposure light which is extreme ultraviolet region light, a protective film formed on the multilayer reflective film for protecting the multilayer reflective film, and a pattern of a light-absorbing film formed on the protective film in contact with the protective film, absorbing the exposure light, and having a phase shift function, wherein
the light-absorbing film has a thickness of 35 nm or more and 40 nm or less,
the light-absorbing film is formed of a material containing platinum (Pt) and ruthenium (Ru),
as an overall average in the light-absorbing film, a content of platinum (Pt) is 40 atomic % or more and less than 60%, a content of ruthenium (Ru) is more than 40 atomic % and 60 atomic % or less, and a total content of platinum (Pt) and ruthenium (Ru) is 96 atomic % or more,
a content of platinum (Pt) on the side of the light-absorbing film farthest from the substrate is more than 50 atomic % and 90 atomic % or less,
a content of platinum (Pt) intermittently or continuously decreases in part or whole of the light-absorbing film along the thickness direction thereof from the side of the light-absorbing film farthest from the substrate toward the substrate side, and
the light-absorbing film has a reflectance of 3% or more and 10% or less with respect to the exposure light and a phase difference of 200 degrees or more and 230 degrees or less with respect to the exposure light.

10. The reflective photomask according to claim 9, wherein a content of platinum (Pt) on the side of the light-absorbing film closest to the substrate is 40 atomic % or more and 50 atomic % or less.

11. The reflective photomask according to claim 9 or 10, wherein the content of platinum (Pt) on the side of the light-absorbing film farthest from the substrate is 52 atomic % or more.

12. The reflective photomask according to any one of claims 9 to 11, wherein, when the protective film and the light-absorbing film are etched under the same conditions by dry etching performed with activating a fluorine-based gas by an electron beam, a ratio of an etching rate of the light-absorbing film to an etching rate of the protective film is 50 or more.

13. The reflective photomask according to any one of claims 9 to 12, wherein the protective film is formed of a material containing rhodium (Rh).

14. A method for producing a reflective photomask comprising a pattern of the light-absorbing film from the reflective photomask blank according to any one of claims 6 to 8, comprising the steps of:
(A) forming a resist film in contact with the side of the hard mask film farthest from the substrate,
(B) patterning the resist film to form a resist pattern,
(C) patterning the hard mask film by dry etching using a chlorine-based gas with the resist pattern used as an etching mask to form a pattern of the hard mask film,
(D) removing the resist pattern,
(E) patterning the light-absorbing film by dry etching using a fluorine-based gas with the pattern of the hard mask film used as an etching mask to form a pattern of the light-absorbing film, and
(F) removing the pattern of the hard mask film by dry etching using a chlorine-based gas.
